# EUROPEAN PATENT APPLICATION

(11) **EP 4 645 370 A1**
(43) Date of publication of application: **05.11.2025**
(21) Application number: 23911535.5
(22) Date of filing: 01.12.2023
(51) Int. Cl.: H01L 21/205, C30B 29/38

(54) **METHOD FOR PRODUCING EPITAXIAL SUBSTRATE, AND EPITAXIAL SUBSTRATE**

(30) Priority: 28.12.2022 JP 2022211189
(71) Applicant: Shin-Etsu Handotai Co., Ltd., Tokyo 100-0004 (JP)
(72) Inventor: HAGIMOTO, Kazunori, Annaka-shi, Gunma 379-0196 (JP); TSUCHIYA, Keitaro, Annaka-shi, Gunma 379-0196 (JP); KUBONO, Ippei, Annaka-shi, Gunma 379-0196 (JP)
(74) Representative: Schicker, Silvia
(86) International application number: PCT/JP2023/043038
(87) International publication number: WO 2024/142754

(57) **Abstract**

The present invention is a method of manufacturing an epitaxial substrate, in which: a single-crystal Si substrate with a thickness equal to or greater than 1,500 µm is used, resistivity of the single-crystal Si substrate and a ratio "a" (a thickness of the single-crystal Si substrate/a thickness of a group-III nitride epitaxial layer) are set as parameters, an epitaxial growth of the group-III nitride epitaxial layer on the single-crystal Si substrate and measurement about a warp of the obtained epitaxial substrate are performed while the parameters are changed, and a correlation between the ratio "a" and the warp of the epitaxial substrate is obtained for each value of the resistivity of the single-crystal Si substrate; manufacturing parameters with which an absolute value of the warp of the epitaxial substrate becomes equal to or smaller than 50 µm are determined based on the correlation; and the group-III nitride epitaxial layer is caused to epitaxially grow on the single-crystal Si substrate by using the determined manufacturing parameters. Accordingly, an epitaxial substrate in which withstand voltage characteristics are high and |warp| ≤ 50 µm is achieved and a method of manufacturing an epitaxial substrate in which such an epitaxial substrate can be obtained are provided.

## Description

### TECHNICAL FIELD

The present invention relates to a method of manufacturing an epitaxial substrate and an epitaxial substrate.

### BACKGROUND ART

A group-III nitride semiconductor, including a group-III nitride such as GaN or AlN, has been expected to be a next-generation semiconductor material that surpasses limitations of Si (silicon) as a material. Because it is possible with the group-III nitride semiconductor to create a high-electron-mobility transistor (HEMT) which uses a two-dimensional electron gas, practical application of the group-III nitride semiconductor as a semiconductor device for high frequency use has been expected. Further, the above group-III nitride semiconductor is also a piezoelectric material with excellent mechanical properties, and its use in a communication high frequency filter, a sensor, an energy harvester, and so forth has also been expected. In recent years, a high frequency device has been manufactured by performing an epitaxial growth of the group-III nitride on a Si single-crystal substrate.

### CITATION LIST

### PATENT LITERATURE

Patent Document 1: JP 2015-176936 A
Patent Document 2: JP 2014-216474 A
Patent Document 3: JP 2011-103380 A
Patent Document 4: JP 2003-063897 A

### SUMMARY OF INVENTION

### TECHNICAL PROBLEM

In order to obtain a high withstand voltage in an epitaxial substrate including an epitaxial layer of a group-III nitride on a Si single-crystal substrate such as a GaN-on-Si substrate, a method has been known in which the high withstand voltage is obtained by thickening a film thickness of the epitaxial layer of the group-III nitride such as GaN or by C doping (Patent Document 1). However, there is a problem that a warp of the epitaxial substrate becomes large due to thickening of the film thickness of the epitaxial layer.

Patent Document 2 describes a relationship of a B dopant concentration and the thickness of the epitaxial layer with the warp but does not mention a relationship between a thickness of a Si substrate and the warp and does not mention a (substrate/epitaxial) thickness ratio which is suitable for different resistivity, either.

Patent Document 3 discloses that when the thickness of the epitaxial layer is 8 µm, a warp of a nitride semiconductor substrate is 24 µm but a diameter of the Si substrate is 4 inches (100 mm). Because the warp becomes larger in accordance with an increase in the diameter of the substrate, an additional measure becomes necessary in order to achieve the warp, whose absolute value is equal to or smaller than 50 µm (which might be expressed as "|warp| ≤ 50 µm"), with a larger diameter. For example, when the inventors performed an observation by using a Si substrate with a diameter of 300 mm and a thickness of 1.5 mm, fracture occurred due to exertion of a too large stress at an epitaxial thickness of 5.7 µm even in ranges of an oxygen concentration and resistivity in Claim 2 of Patent Document 3.

Further, Patent Document 4 discloses a technique in which an epitaxial layer thickness/substrate thickness ratio ≤ 0.011 and a substrate thickness ≥ 450 µm are set for warp suppression. However, the diameter of the substrate in an example in Patent Document 4 is 5 cm, and a GaN layer thickness is only up to 7 µm. When the inventors performed an investigation, it was observed that in a case where the thickness of the epitaxial layer of the group-III nitride was further thickened exceeding 7 µm, a withstand voltage was further improved. For example, when a bias voltage at a time when a leakage current reached 1 × 10⁻⁶ A/mm² was set as the withstand voltage, the withstand voltage was 900 V in a case where the thickness of the epitaxial layer of the group-III nitride was 6.5 µm, but the withstand voltage was 1,000 V in a case where the thickness of the epitaxial layer of the group-III nitride was 7.5 µm. Note that in the latter case, the thickness of the substrate was also increased in order to make the absolute value of the warp become equal to or smaller than 50 µm, but the used substrate had a low resistivity of 5 mΩcm, an effect of increasing the withstand voltage by increasing the thickness of the substrate was not obtained, and a rise of the withstand voltage was due to the increase in the thickness of the epitaxial layer. As described above, when the thickness of the epitaxial layer of the group-III nitride is further thickened exceeding 7 µm, a nitride semiconductor substrate suitable for a higher withstand voltage device can be obtained. Thus, an epitaxial substrate has been demanded that includes an epitaxial layer of the group-III nitride in which the film thickness of the epitaxial layer of the group-III nitride exceeds 7 µm and the absolute value of the warp is equal to or smaller than 50 µm.

The present invention has been made for solving the above problems, and an object of the present invention is to provide an epitaxial substrate for a semiconductor device that is capable of suppressing an absolute value of a warp of an epitaxial substrate to a value equal to or smaller than 50 µm (|warp| ≤ 50 µm) while a thickness of a group-III nitride epitaxial layer is made thicker than 7 µm in order to obtain a higher withstand voltage and a method of manufacturing an epitaxial substrate which can easily and stably obtain such an epitaxial substrate.

### SOLUTION TO PROBLEM

The present invention has been made for achieving the above object and provides a method of manufacturing an epitaxial substrate including a single-crystal Si substrate and a group-III nitride epitaxial layer on the single-crystal Si substrate, the method including: a correlation acquisition step in which a single-crystal Si substrate with a thickness equal to or greater than 1,500 µm is used, resistivity of the single-crystal Si substrate and a ratio "a" between a thickness of the single-crystal Si substrate and a thickness of the group-III nitride epitaxial layer (the thickness of the single-crystal Si substrate/the thickness of the group-III nitride epitaxial layer) are set as parameters, an epitaxial growth of the group-III nitride epitaxial layer on the single-crystal Si substrate and measurement about a warp of the obtained epitaxial substrate are performed while the parameters are changed, and a correlation between the ratio "a" and the warp of the epitaxial substrate is obtained for each value of the resistivity of the single-crystal Si substrate; a manufacturing parameter determination step of determining the resistivity of the single-crystal Si substrate and the ratio "a", with which an absolute value of the warp of the epitaxial substrate becomes equal to or smaller than 50 µm based on the correlation; and an epitaxial substrate manufacturing step of epitaxially growing the group-III nitride epitaxial layer on the single-crystal Si substrate by using the determined manufacturing parameters.

In such a method of manufacturing the epitaxial substrate, the warp can be suppressed while withstand voltage characteristics are enhanced, and the epitaxial substrate with |warp| ≤ 50 µm can easily and stably be obtained.

The present invention has been made for achieving the above object and provides an epitaxial substrate including a single-crystal Si substrate and a group-III nitride epitaxial layer on the single-crystal Si substrate, the epitaxial substrate having a diameter equal to or shorter than 150 mm, in which a thickness of the single-crystal Si substrate is equal to or greater than 1,500 µm, a thickness of the group-III nitride epitaxial layer is thicker than 7 µm, and when a ratio between the thickness of the single-crystal Si substrate and the thickness of the group-III nitride epitaxial layer (the thickness of the single-crystal Si substrate/the thickness of the group-III nitride epitaxial layer) is set as "a", at least one of the following (A) to (C) is satisfied:
(A) resistivity of the single-crystal Si substrate is equal to or lower than 2 mΩcm and the ratio "a" is equal to or higher than 125;
(B) the resistivity of the single-crystal Si substrate is equal to or lower than 3 mΩcm and the ratio "a" is equal to or higher than 135; and
(C) the resistivity of the single-crystal Si substrate is equal to or lower than 5 mΩcm and the ratio "a" is equal to or higher than 137.

In such an epitaxial substrate, the withstand voltage characteristics are high, the warp is suppressed, and |warp| ≤ 50 µm is achieved.

In this case, the epitaxial substrate can be provided in which the single-crystal Si substrate is a single-crystal Si substrate with an oxygen concentration of 11 to 18 ppma (JEIDA).

Accordingly, the warp is more stably suppressed.

### ADVANTAGEOUS EFFECTS OF INVENTION

As described above, a method of manufacturing an epitaxial substrate of the present invention makes it possible to easily and stably obtain an epitaxial substrate that suppresses a warp while enhancing withstand voltage characteristics and achieves |warp| ≤ 50 µm. In an epitaxial substrate of the present invention, the withstand voltage characteristics are high, the warp is suppressed, and |warp| ≤ 50 µm is achieved.

### BRIEF DESCRIPTION OF DRAWINGS

FIG. 1 illustrates one example of a structure of an epitaxial substrate according to the present invention;
FIG. 2 illustrates a relationship between a ratio "a" between a thickness of a single-crystal Si substrate 1 and a thickness of a group-III nitride epitaxial layer 2 (the thickness of the single-crystal Si substrate/the thickness of the group-III nitride epitaxial layer) and an absolute value of a warp of an epitaxial substrate 100, the relationship being obtained for each value of resistivity of the single-crystal Si substrate 1 (a thickness of 1,500 µm);
FIG. 3 is a diagram in which a part of FIG. 2 is enlarged; and
FIG. 4 illustrates a relationship between the ratio "a" and the warp in accordance with a difference in the thickness of the single-crystal Si substrate.

### DESCRIPTION OF EMBODIMENTS

The present invention will hereinafter be described in detail, but the present invention is not limited to those descriptions.

As described above, an epitaxial substrate in which withstand voltage characteristics are high, a warp is suppressed, and |warp| ≤ 50 µm is achieved and a method of manufacturing an epitaxial substrate in which such an epitaxial substrate can easily and stably be obtained have been demanded.

The present inventors have conducted intensive studies about the above problems, have as a result found that an epitaxial substrate, in which the warp is suppressed while the withstand voltage characteristics are enhanced and |warp| ≤ 50 µm is achieved, can easily and stably be obtained by a method of manufacturing an epitaxial substrate including a single-crystal Si substrate and a group-III nitride epitaxial layer on the single-crystal Si substrate, the method including: a correlation acquisition step in which a single-crystal Si substrate with a thickness equal to or greater than 1,500 µm is used, resistivity of the single-crystal Si substrate and a ratio "a" between a thickness of the single-crystal Si substrate and a thickness of the group-III nitride epitaxial layer (the thickness of the single-crystal Si substrate/the thickness of the group-III nitride epitaxial layer) are set as parameters, an epitaxial growth of the group-III nitride epitaxial layer on the single-crystal Si substrate and measurement about a warp of the obtained epitaxial substrate are performed while the parameters are changed, and a correlation between the ratio "a" and the warp of the epitaxial substrate is obtained for each value of the resistivity of the single-crystal Si substrate; a manufacturing parameter determination step of determining the resistivity of the single-crystal Si substrate and the ratio "a", with which an absolute value of the warp of the epitaxial substrate becomes equal to or smaller than 50 µm based on the correlation; and an epitaxial substrate manufacturing step of epitaxially growing the group-III nitride epitaxial layer on the single-crystal Si substrate by using the determined manufacturing parameters, and have accomplished the present invention.

Further, the present inventors have found that the withstand voltage characteristics become high, the warp is suppressed, and |warp| ≤ 50 µm is achieved by an epitaxial substrate including a single-crystal Si substrate and a group-III nitride epitaxial layer on the single-crystal Si substrate, the epitaxial substrate having a diameter equal to or shorter than 150 mm, in which a thickness of the single-crystal Si substrate is equal to or greater than 1,500 µm, a thickness of the group-III nitride epitaxial layer is thicker than 7 µm, and when a ratio between the thickness of the single-crystal Si substrate and the thickness of the group-III nitride epitaxial layer (the thickness of the single-crystal Si substrate/the thickness of the group-III nitride epitaxial layer) is set as "a", at least one of the following (A) to (C) is satisfied, and have accomplished the present invention.
(A) Resistivity of the single-crystal Si substrate is equal to or lower than 2 mΩcm and the ratio "a" is equal to or higher than 125;
(B) the resistivity of the single-crystal Si substrate is equal to or lower than 3 mΩcm and the ratio "a" is equal to or higher than 135; and
(C) the resistivity of the single-crystal Si substrate is equal to or lower than 5 mΩcm and the ratio "a" is equal to or higher than 137.

In the following, a description will be made with reference to drawings.

### [Epitaxial Substrate]

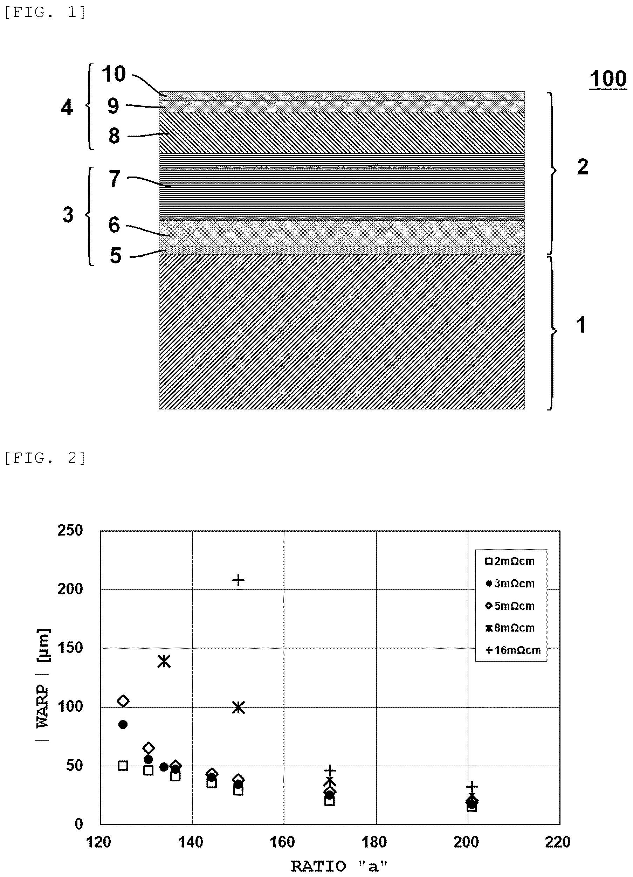

First, the epitaxial substrate according to the present invention will be described with reference to an example in FIG. 1. As illustrated in FIG. 1, an epitaxial substrate 100 according to the present invention includes a single-crystal Si substrate 1 and a group-III nitride epitaxial layer 2. Further, the epitaxial substrate 100 according to the present invention is an epitaxial substrate with a diameter equal to or smaller than 150 mm (6 inches). Note that a lower limit value of the diameter of the epitaxial substrate 100 is not particularly limited. For example, the diameter can be set to 10 mm or greater, preferably 25 mm (1 inch) or greater, and further preferably 50 mm (2 inches) or greater.

A thickness of the single-crystal Si substrate 1 is 1,500 µm (1.5 mm) or greater. The single-crystal Si substrate 1 with such a thickness provides a high effect of suppressing the warp. Further, a thickness of the group-III nitride epitaxial layer 2 is thicker than 7 µm. The group-III nitride epitaxial layer 2 with such a thickness has high withstand voltage characteristics. Note that an upper limit value of the thickness of the single-crystal Si substrate 1 is not particularly limited. For example, it is possible to set a thickness of 5,000 µm (5.0 mm) or smaller, preferably a thickness of 3,000 µm (3.0 mm) or smaller, and further preferably a thickness of 2,000 µm (2.0 mm) or smaller. Further, an upper limit value of the thickness of the group-III nitride epitaxial layer 2 is not particularly limited. For example, it is possible to set a thickness of 50 µm or smaller, preferably a thickness of 30 µm or smaller, and further preferably a thickness of 20 µm or smaller.

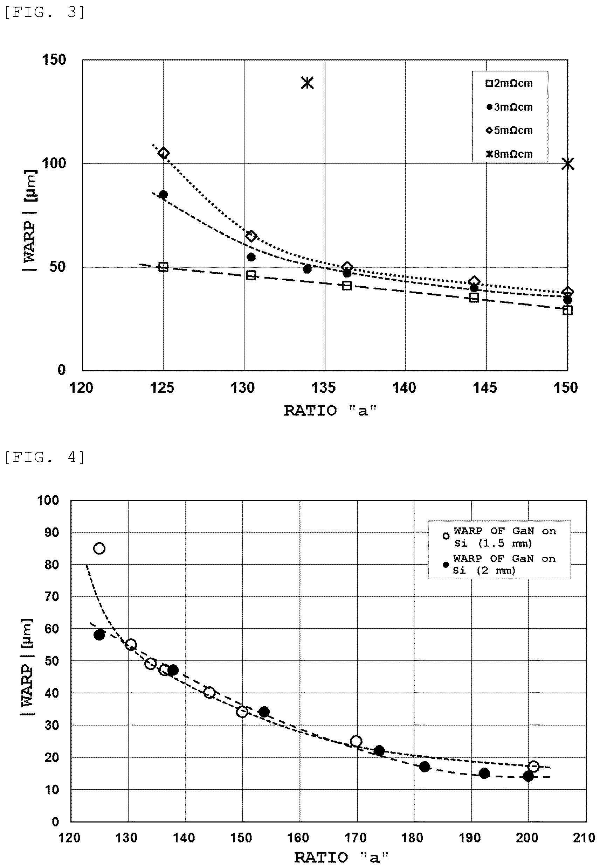

FIG. 2 illustrates a relationship between the ratio "a" between the thickness of the single-crystal Si substrate 1 and the thickness of the group-III nitride epitaxial layer 2 (the thickness of the single-crystal Si substrate/the thickness of the group-III nitride epitaxial layer) and the absolute value of the warp (|warp|) of the epitaxial substrate 100, the relationship being obtained for each value of the resistivity of the single-crystal Si substrate 1 (a thickness of 1,500 µm). As illustrated in FIG. 2, it can be understood that in a case where the resistivity of the single-crystal Si substrate 1 is the same, when the ratio "a" between the thickness of the single-crystal Si substrate 1 and the thickness of the group-III nitride epitaxial layer 2 (which might hereinafter be referred to simply as "ratio 'a'") becomes higher, the absolute value of the warp of the epitaxial substrate 100 becomes smaller. FIG. 3 is a diagram in which a partial region of FIG. 2 is enlarged. Based on FIG. 3, it can be understood that when the resistivity of the single-crystal Si substrate 1 and the ratio "a" are in appropriate ranges, the epitaxial substrate with |warp| ≤ 50 µm is obtained. Note that a lower limit value of the absolute value of the warp (|warp|) of the epitaxial substrate 100 is 0 µm. Further, as it is clear from FIGs. 2 and 3 that it is further preferable that the resistivity of the single-crystal Si substrate 1 be lower, and a lower limit value of the resistivity of the single-crystal Si substrate 1 is not particularly limited. For example, the lower limit value of the resistivity of the single-crystal Si substrate 1 can be set to a value equal to or greater than 0.0001 mΩcm.

Specifically, from FIG. 3, when
(A) the resistivity of the single-crystal Si substrate is equal to or lower than 2 mΩcm and the ratio "a" is equal to or higher than 125;
(B) the resistivity of the single-crystal Si substrate is equal to or lower than 3 mΩcm and the ratio "a" is equal to or higher than 135; or
(C) the resistivity of the single-crystal Si substrate is equal to or lower than 5 mΩcm and the ratio "a" is equal to or higher than 137,
   the epitaxial substrate with |warp| ≤ 50 µm is obtained.

Further, as it can be understood from FIG. 2, in a range in which the resistivity exceeds 5 mΩcm, a change in |warp| becomes extremely large with respect to a change in the ratio "a", and a correlation curve between the ratio "a" and |warp| has a steep slope. Thus, the range of the ratio "a" which can be set for achieving |warp| ≤ 50 µm is narrow, that is, an adjustability range of the epitaxial layer is narrow. In addition, due to such a slope of the correlation curve, variation of the warp due to a fluctuation in the ratio "a" tends to become large, and stable control might not be able to be performed. For such reasons, in the epitaxial substrate according to the present invention, as the single-crystal Si substrate 1, a single-crystal Si substrate with a resistivity equal to or lower than 5 mΩcm is used.

Note that by an investigation by the present inventors, it has been observed that in a range in which the thickness of the single-crystal Si substrate is equal to or greater than 1,500 µm (1.5 mm), an influence of the thickness of the single-crystal Si substrate, which is exerted on the correlation, is low. FIG. 4 is a diagram in which the resistivity of the single-crystal Si substrate is set to 3 mΩcm and cases where the thickness of the single-crystal Si substrate is 1,500 µm (1.5 mm) and where the thickness of the single-crystal Si substrate is 2,000 µm (2.0 mm) are compared. As illustrated in FIG. 4, around a condition of |warp| ≤ 50 µm, the influence of the thickness of the single-crystal Si substrate which is exerted on the correlation can be at a negligible level.

In the following, again referring to FIG. 1, a more specific description will be made about each configuration of the epitaxial substrate 100 according to the present invention.

### (Single-Crystal Si Substrate)

Next, the single-crystal Si substrate 1 will be described. The resistivity of the single-crystal Si substrate may be formed with a single wafer and may be a bonded substrate in which a plurality of single-crystal Si wafers are bonded together in order to secure a thickness equal to or greater than 1,500 µm. A form of the bonded substrate may be a form in which substrates are directly pasted to each other or a form of the bonded substrate which are bonded while an oxide film is interposed.

An oxygen concentration of the single-crystal Si substrate 1 is not particularly limited, but an oxygen concentration of 11 to 18 ppma (JEIDA) is preferable. In the oxygen concentration in such a range, the warp is stably suppressed. Note that in the present specification, values of the oxygen concentration are based on the JEIDA-61-2000 standard.

### (Group-III Nitride Epitaxial Layer)

Next, the group-III nitride epitaxial layer 2 will be described. The group-III nitride epitaxial layer 2 according to the present invention is not particularly limited as long as that is an epitaxial layer of a group-III nitride and can include a buffer layer 3 and a device layer 4, for example. The buffer layer 3 may include an initial layer 5 and another layer 6 and may further include a superlattice layer 7. The device layer 4 may include a GaN layer 8, a barrier layer 9, a cap layer 10, and so forth, for example.

In a case where the group-III nitride epitaxial layer 2 includes GaN, as the buffer layer, for example, the initial layer of AlN and an AlGaN layer or GaN layer provided thereon can be raised as examples. Further, as the superlattice layer 7, a repeated structure of Al₁₋ₓGaₓN/GaN and so forth can be raised as examples.

### [Method of Manufacturing Epitaxial Substrate]

Next, the method of manufacturing the epitaxial substrate according to the present invention will be described. The method of manufacturing the epitaxial substrate according to the present invention is a method of manufacturing an epitaxial substrate including a single-crystal Si substrate and a group-III nitride epitaxial layer thereon, the epitaxial substrate achieving |warp| ≤ 50 µm. In the following, a description will separately be made about each step. Note that descriptions about similar items to items described for the above epitaxial substrate will appropriately be skipped.

### (Correlation Acquisition Step)

In a correlation acquisition step, the single-crystal Si substrate 1 with a thickness equal to or greater than 1,500 µm is used. Then, the resistivity of the single-crystal Si substrate 1 and the ratio "a" between the thickness of the single-crystal Si substrate and the thickness of the group-III nitride epitaxial layer (the thickness of the single-crystal Si substrate/the thickness of the group-III nitride epitaxial layer) are set as parameters, and an epitaxial growth of the group-III nitride epitaxial layer on the single-crystal Si substrate is performed. While the above-described parameters are changed, the epitaxial growth is repeatedly performed. For example, in a case where the thickness and the resistivity of the single-crystal Si substrate, which is used in an actual epitaxial substrate manufacturing step, are defined, the thickness and the resistivity of the single-crystal Si substrate are fixed, and the epitaxial growth may thereby be performed while the thickness of the group-III nitride epitaxial layer is varied. It goes without saying that the epitaxial growth may be performed while all conditions are varied. Subsequently, the warp of the epitaxial substrate obtained by the epitaxial growth is measured.

In an example of a standard condition of the epitaxial growth, on a Si substrate with a predetermined thickness, as the buffer layer, an initial layer AlN (a thickness of 150 nm), the AlGaN layer (a thickness of 50 nm), and the GaN layer (a thickness of 50 nm) are grown, the superlattice layer (SLs structure: a repeated structure of Al₁₋ₓGaₓN with a thickness of 2 to 10 nm/GaN with a thickness of 2 to 15 nm) is grown for 6.6 µm on those, and further on the above buffer layer, as the device layer, the GaN layer (a thickness of 4.4 µm), an AlGaN barrier layer (a thickness of 23 nm), and GaN-Cap layer (a thickness of 3 nm) are grown. In a case where the thickness (total film thickness) of the epitaxial layer of the group-III nitride is adjusted in order to acquire the correlation, a standard epitaxial layer of the group-III nitride as described above is set as a reference, and a whole thickness is thereby adjusted while a rate between the buffer layer and the device layer is maintained the same. Among the layers, because ratios of film thicknesses of the superlattice layer in the buffer layer and of the GaN layer in the device layer are high in the respective layers, it is preferable to adjust those film thicknesses.

From the above-described parameters and measurement results, the correlation between the ratio "a" and the warp of the epitaxial substrate is obtained. For example, correlations, as illustrated in FIGs. 2 and 3, between the ratio "a" and the absolute value of the warp of the epitaxial substrate can be obtained.

### (Manufacturing Parameter Determination Step)

By using the correlation which is obtained as described above, conditions for making the absolute value of the warp of the epitaxial substrate become equal to or smaller than 50 µm, that is, the resistivity of the single-crystal Si substrate and the ratio "a" are determined. For example, conditions for achieving |warp| ≤ 50 µm can be selected from FIGs. 2 and 3 and can easily be determined as the manufacturing parameters.

### (Epitaxial Substrate Manufacturing Step)

The group-III nitride epitaxial layer is caused to epitaxially grow on the single-crystal Si substrate by using the manufacturing parameters which are determined as described above, and the epitaxial substrate with |warp| ≤ 50 µm can thereby be obtained.

Note that an apparatus to be used for measurement of the warp is not particularly limited. For example, the measurement can be performed by using the OPTM produced by Otsuka Electronics Co., Ltd.

A procedure of the epitaxial growth is not particularly limited as long as a group-III nitride film can be formed, and thermal CVD, MOVPE, MBE, and so forth can be raised. An epitaxial growth condition is not particularly limited. Examples to be raised are as follows: 1,050°C to 1,200°C in a case where AlN of the initial layer is grown as a part of the buffer layer in the epitaxial layer; 1,150°C to 1,050°C in a case where the AlGaN layer is grown; 1,100°C to 1,000°C in a case where the superlattice layer is grown; 900°C to 1,000°C in a case where the GaN layer is grown as a part of the device layer; and so forth.

### EXAMPLE

In the following, a description of the present invention will specifically be made while examples are raised, but those do not limit the present invention.

### (Example 1)

First, a Si substrate with a diameter of 150 mm (6 inches) and a thickness of 1,500 µm was prepared. Levels of the resistivity of the Si substrate were set to 2, 3, 5, 8, and 16 mΩcm. The group-III nitride epitaxial layer was caused to grow on the prepared Si substrate, and the epitaxial substrate was thereby obtained. In this case, the film thickness of the group-III nitride epitaxial layer was changed, and the ratio "a" between the thickness of the Si substrate and the thickness of the group-III nitride epitaxial layer (the thickness of the single-crystal Si substrate/the thickness of the group-III nitride epitaxial layer) as the parameter was thereby varied.

More specifically, as the group-III nitride epitaxial layer, the buffer layer (the initial layer AlN, the AlGaN layer, the GaN layer, and the superlattice layer (the repeated structure of Al₁₋ₓGaₓN with a thickness of 2 to 10 nm/GaN with a thickness of 2 to 15 nm) and the device layer (the GaN layer, the AlGaN barrier layer, and the GaN-Cap layer) on that were grown. In a case where the thickness of the group-III nitride epitaxial layer was changed, a total thickness of the whole group-III nitride epitaxial layer was changed while the rate between the buffer layer and the device layer was maintained the same.

Measurement about a warp of the epitaxial substrates created in such a manner was performed. Then, when the ratios "a" and the warps (absolute values) were acquired and the correlations between those were obtained, the correlations illustrated in FIGs. 2 and 3 were able to be obtained.

Based on the correlations obtained as described above, the conditions for achieving |warp| ≤ 50 µm, that is, the Si substrate with a resistivity of 3 mΩcm was employed, and a condition where the ratio "a" exceeded 135 was employed. Specifically, the Si substrate with a resistivity of 3 mΩcm, an oxygen concentration of 14.7 ppma (JEIDA), and a thickness of 1,500 µm was prepared. As for the growth of the epitaxial layer, specifically, the AlGaN layer (a thickness of 50 nm) and the GaN layer (a thickness of 50 nm) were grown on the initial layer AlN (a thickness of 150 nm). On that, the superlattice layer (SLs structure: the repeated structure of Al₁₋ₓGaₓN with a thickness of 2 to 10 nm/GaN with a thickness of 2 to 15 nm) (a thickness of 6.5 µm) was grown. Further on that, the GaN layer (a thickness of 4.2 µm) and the AlGaN barrier layer (a thickness of 23 nm) were grown, and on that, the GaN-Cap layer (a thickness of 3 nm) was grown. In this case, the film thickness of the epitaxial layer is 11.0 µm, and the ratio "a" is 136.4. Further, the thickness of the epitaxial layer was changed from this condition as indicated in Table 1, and manufacture of the epitaxial substrate and evaluation of the warp were performed. In the example 1, the warp of the epitaxial substrate was equal to or smaller than ±50 µm (|warp| ≤ 50 µm).

### (Comparative Example 1)

The Si substrate with a resistivity of 3 mΩcm the same as the example 1 was used, but when the film thickness of the epitaxial layer was set to 11.5 µm, the warp exceeded ±50 µm. In this case, the ratio "a" was 130.4, which was below the condition of 135.

### (Comparative Example 2)

The Si substrate with a resistivity of 3 mΩcm the same as the example 1 was used, but when the film thickness of the epitaxial layer was set to 12.0 µm, the warp exceeded ±50 µm. In this case, the ratio "a" was 125.0, which was below the condition of 135.

### (Comparative Example 3)

The Si substrate with a resistivity of 16 mΩcm and an oxygen concentration of 17.0 ppma (JEIDA) was prepared. When the film thickness of the epitaxial layer became 10 µm, the warp became as large as -208 µm.

### (Comparative Example 4)

The Si substrate with a resistivity of 8 mΩcm, an oxygen concentration of 10.5 ppma (JEIDA), and a thickness of 1,000 µm was prepared, and the epitaxial layer with a thickness of 7.47 µm was grown. The warp became as large as -209 µm. Note that in this case, the ratio "a" was 134.

Table 1 summarizes conditions and results of the example 1 and the comparative examples 1-4.

**[Table 1]**

| **150mmΦ** | Substrate [µm] | Resistivity and Oxygen Concentration | Warp [µm] | Epitaxial Thicknes s [µm] | substrate Thickness/ Epitaxial Thickness |
|---|---|---|---|---|---|
| Example 1 | **1500** | **3mΩcm, 12~16ppma** | **17** | **7.47** | **200.8** |
| | **1500** | **3mΩcm, 12~16ppma** | **25** | **8.83** | **169.9** |
| | **1500** | **3mΩcm, 12~16ppma** | **34** | **10.0** | **150.0** |
| | **1500** | **3mΩcm, 12~16ppma** | **40** | **10.4** | **144.2** |
| | **1500** | **3mΩcm, 12~16ppma** | **47** | **11.0** | **136.4** |
| Comparative Example 1 | **1500** | **3mΩcm, 12~16ppma** | **55** | **11.5** | **130.4** |
| Comparative Example 2 | **1500** | **3mΩcm, 12~16ppma** | **85** | **12.0** | **125.0** |
| Comparative Example 3 | **1500** | **16mΩcm, 17ppma** | **-208** | **10.0** | **150.0** |
| Comparative Example 4 | **1000** | **8mΩcm, 8~12ppma** | **-209** | **7.47** | **133.9** |

As described above, in the example of the present invention, an epitaxial substrate was able to be obtained in which the withstand voltage characteristics were high and the warp was suppressed as |warp| ≤ 50 µm. could be caused.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method of manufacturing an epitaxial substrate including a single-crystal Si substrate and a group-III nitride epitaxial layer on the single-crystal Si substrate, the method comprising:
a correlation acquisition step in which a single-crystal Si substrate with a thickness equal to or greater than 1,500 µm is used, resistivity of the single-crystal Si substrate and a ratio "a" between a thickness of the single-crystal Si substrate and a thickness of the group-III nitride epitaxial layer (the thickness of the single-crystal Si substrate/the thickness of the group-III nitride epitaxial layer) are set as parameters, an epitaxial growth of the group-III nitride epitaxial layer on the single-crystal Si substrate and measurement about a warp of the obtained epitaxial substrate are performed while the parameters are changed, and a correlation between the ratio "a" and the warp of the epitaxial substrate is obtained for each value of the resistivity of the single-crystal Si substrate;
a manufacturing parameter determination step of determining the resistivity of the single-crystal Si substrate and the ratio "a", with which an absolute value of the warp of the epitaxial substrate becomes equal to or smaller than 50 µm based on the correlation; and
an epitaxial substrate manufacturing step of epitaxially growing the group-III nitride epitaxial layer on the single-crystal Si substrate by using the determined manufacturing parameters.

2. An epitaxial substrate including a single-crystal Si substrate and a group-III nitride epitaxial layer on the single-crystal Si substrate, the epitaxial substrate having a diameter equal to or shorter than 150 mm, wherein
a thickness of the single-crystal Si substrate is equal to or greater than 1,500 µm, a thickness of the group-III nitride epitaxial layer is thicker than 7 µm, and
when a ratio between the thickness of the single-crystal Si substrate and the thickness of the group-III nitride epitaxial layer (the thickness of the single-crystal Si substrate/the thickness of the group-III nitride epitaxial layer) is set as "a", at least one of the following (A) to (C) is satisfied:
(A) resistivity of the single-crystal Si substrate is equal to or lower than 2 mΩcm and the ratio "a" is equal to or higher than 125;
(B) resistivity of the single-crystal Si substrate is equal to or lower than 3 mΩcm and the ratio "a" is equal to or higher than 135; and
(C) resistivity of the single-crystal Si substrate is equal to or lower than 5 mΩcm and the ratio "a" is equal to or higher than 137.

3. The epitaxial substrate according to claim 2, wherein
the single-crystal Si substrate is a single-crystal Si substrate with an oxygen concentration of 11 to 18 ppma (JEIDA).
